# EUROPEAN PATENT APPLICATION

(11) **EP 2 178 094 A1**
(43) Date of publication of application: **21.04.2010**
(21) Application number: 08791996.5
(22) Date of filing: 31.07.2008
(51) Int. Cl.: H01B 1/22, C09J 5/00, C09J 9/02, C09J 11/04, C09J 163/00, H01B 1/00, H01L 21/60, H01R 11/01, H05K 1/14, H05K 3/32, H05K 3/36

(54) **CIRCUIT CONNECTION MATERIAL, AND CONNECTION STRUCTURE OF CIRCUIT MEMBER AND CONNECTION METHOD OF CIRCUIT MEMBER USING THE CIRCUIT CONNECTION MATERIAL**

(30) Priority: 02.08.2007 JP 2007201800
(71) Applicant: Hitachi Chemical Company, Ltd., Tokyo 163-0449 (JP)
(72) Inventor: TOMISAKA, Katsuhiko, Chikusei-shi Ibaraki 308-8524 (JP); KOBAYASHI, Kouji, Chikusei-shi Ibaraki 308-8524 (JP); TAKETATSU, Jun, Chikusei-shi Ibaraki 308-8524 (JP); ARIFUKU, Motohiro, Chikusei-shi Ibaraki 308-8524 (JP); KOJIMA, Kazuyoshi, Chikusei-shi Ibaraki 308-8524 (JP); MOCHIZUKI, Nichiomi, Chikusei-shi Ibaraki 308-8524 (JP)
(74) Representative: HOFFMANN EITLE
(86) International application number: PCT/JP2008/063781
(87) International publication number: WO 2009/017200

(57) **Abstract**

A circuit connection material 10 comprising an adhesive composition 11 and conductive particles 12, wherein the conductive particles 12 are conductive particles 12 with protrusions 14 comprising one or more metal layers 22 on a core 21, with the metal layer 22 being formed on at least surfaces of the protrusions 14 and the metal layer 22 being composed of nickel or a nickel alloy, and compression modulus of the conductive particles 12 under 20% compression is 100-800 kgf/mm².

## Description

### Technical Field

The present invention relates to a circuit connection material, and to a connection structure for a circuit member and a connection method for a circuit member using the circuit connection material.

### Background Art

Mounting of liquid crystal driving ICs on liquid crystal display glass panels is accomplished by Chip-On-Glass mounting (hereinafter referred to as COG mounting) methods in which a liquid crystal driving IC is bonded directly onto a glass panel with a circuit-connecting member, and Chip-On-Flex mounting (hereinafter referred to as COF mounting) methods in which a liquid crystal driving IC is bonded to a flexible tape having metal wiring, and then bonded to a glass panel with a circuit-connecting member. Connection between such circuit members that have microcircuits formed therein is difficult to establish with conventional solder or rubber connectors, and therefore anisotropic conductive adhesive compositions are used.

However, with the higher definition of liquid crystal displays in recent years, the densities of circuit electrodes formed on circuit members continue to increase. Thus, circuit electrodes are becoming ever more micronized, i.e. toward higher definitions that require increasing numbers of electrodes and narrower pitches, and consequently a demand exists for high connection reliability in high definition liquid crystal modules. On the other hand, formation of circuit electrodes is accomplished by a process in which the metal material for the circuit is formed over the entire surface of the board, a resist is coated onto the circuit electrode sections and is cured, and the other sections are etched with an acid or base; however, with the high-density circuits mentioned above, the etching time differs between hills and valleys if the irregularities in the metal formed over the entire surface of the board are large, thus making it impossible to accomplish fine etching and leading to problems such as shorting between adjacent circuits or wire breakage. It is therefore desirable for the hills and valleys on the electrode surface of high-density circuits to be minimal, i.e. for the electrode surface to be flat, but when mutually opposing flat circuit electrodes are connected using the conventional circuit connection materials mentioned above, the adhesive resin remains between the flat electrodes and the conductive particles that are in the circuit connection material, making it impossible to ensure long-term connection reliability and sufficient electrical connection between the opposing circuit electrodes.

In addition, circuit electrodes made of metal materials that readily form oxide films on their surfaces are often used in the production steps for liquid crystal modules, and when conventional circuit connection materials are used, making it impossible to simultaneously both ensure electrical connection attributed to the conductive particles protruding through the oxide film and ensure long-term connection reliability, to a satisfactorily high level.

There have therefore been proposed methods in which protrusions are provided on the surfaces of the conductive particles, so as to penetrate the adhesive composition between the conductive particles and the flat electrodes during circuit connection and contact the circuit electrodes (see Patent document 1), and methods in which metal fine particles are distributed on the surfaces of base particles to obtain conductive particles with their surfaces at least partially covered with a metal plating layer, in order to guarantee sufficient electrical connection and long-term connection reliability even with circuit electrodes that readily form oxide films (see Patent document 2).
[Patent document 1] Japanese Unexamined Patent Publication No. 2005-166438
[Patent document 2] International Patent Publication No. WO07/058159

### Disclosure of the Invention

### Problems to be Solved by the Invention

However, even these methods cannot ensure initial electrical connection or ensure satisfactory connection reliability, resulting in a minimal effect in some cases, depending on the technical specifications such as the material of the circuit electrodes.

The present invention has been accomplished in light of these circumstances, and its object is to provide a circuit connection material that can provide satisfactory electrical connection between opposing circuit electrodes while also sufficiently increasing long-term reliability of electrical characteristics between circuit electrodes, as well as a connection structure for a circuit member and a connection method for a circuit member, that employ the same.

### Means for Solving the Problems

As a result of much diligent research conducted with the aim of solving the aforementioned problems, the present inventors have found that those problems can be attributed to the material of the outermost layer of the conductive particles. Specifically, the outermost layer of the conductive particles in a conventional circuit connection material is a metal film of Au, and because Au is a relatively soft metal, the outermost layer of the conductive particles becomes deformed against the circuit electrodes and fails to become easily embedded in the circuit electrodes, even though the adhesive composition between the conductive particles and flat electrodes is penetrated by the protrusions during circuit connection.

The present inventors have further found, as a result of further diligent research toward solving the aforementioned problems, that connection reliability can be improved by changing the material of the outermost layer of the conductive particles to a harder metal than Au, and the invention has been completed upon this finding.

The present invention provides a circuit connection material comprising an adhesive composition and conductive particles, wherein the conductive particles are conductive particles with protrusions comprising one or more metal layers on a core, with a metal layer formed on at least the surfaces of the protrusions, and the metal layer is composed of nickel or a nickel alloy, the compression modulus of the conductive particles under 20% compression being 100-800 kgf/mm².

For fabrication of a connection structure for a circuit member, the circuit connection material of the invention is situated between two circuit members (hereinafter also referred to as "first and second circuit members") and heat-pressed through the circuit members, for use as an anisotropic conductive adhesive for circuit connection that electrically connects the circuit electrodes. With the circuit connection material of the invention, it is possible to form more satisfactory electrical connection between opposing circuit electrodes via conductive particles while also further increasing the long-term reliability of electrical characteristics between circuit electrodes, compared to structures wherein the metal layer (outermost layer) of the conductive particles is Au. That is, even though the cured adhesive composition intrudes between the conductive particles and the circuit electrodes, the protrusions formed on the surface side of the conductive particles causes the pressure applied by the conductive particles onto the cured adhesive composition to be greater than with conductive particles lacking protrusions so that the protrusions of the conductive particles easily penetrate the cured adhesive composition, while they also penetrate to some extent into the circuit electrodes, thus increasing the contact area between the conductive particles and circuit electrodes. Moreover, nickel (Ni) or nickel alloys used as the outermost layer of conductive particles are harder than Au, and therefore the outermost layer of the conductive particles penetrates more easily into the circuit electrodes, thus allowing the contact area between the conductive particles and circuit electrode to be increased and consequently resulting in more satisfactory long-term reliability of electrical connection and electrical characteristics. In addition, if the compression modulus of the conductive particles at 20% compression is 100-800 kgf/mm² the outermost layer of the conductive particles will become embedded more easily in the circuit electrodes, thus allowing sufficient electrical connection to be established. Furthermore, even if the spacing between circuit electrodes varies significantly with changing temperature, the conductive particles adequately follow the increased spacing between the circuit electrodes so that long-term connection reliability can be ensured.

In this circuit connection material, the heights of the protrusions of the conductive particles are preferably 65-500 nm. A distance between adjacent protrusions on the conductive particles is preferably not greater than 1000 nm. If the heights of the protrusions of the conductive particles and the distance between adjacent protrusions are within these ranges, it will be possible for the protrusions of the conductive particles to penetrate the cured adhesive composition more easily, so that more satisfactory electrical connection and long-term reliability of electrical characteristics can be obtained.

The adhesive composition preferably comprises a film-forming material, an epoxy resin and a latent curing agent. This will allow the effect of the invention to be exhibited more reliably.

The invention provides a connection structure for a circuit member comprising two circuit members having circuit electrodes formed thereon and situated with their circuit electrodes facing each other, and a circuit-connecting member lying between the circuit members and heat-pressed for electrical connection between the circuit electrodes, wherein the circuit-connecting member is a circuit connection material according to the invention or its cured product. Since the connection structure for a circuit member is fabricated using the aforementioned circuit connection material, it is possible to obtain satisfactory electrical connection between the circuit electrodes. The satisfactory electrical connection between the opposing circuit electrodes via the conductive particles is also maintained for prolonged periods by the cured adhesive composition, thus allowing sufficient increase in the long-term reliability of the electrical characteristics.

At least one of the pair of circuit members in the connection structure of the invention may be an IC chip. A surface of at least one of the circuit electrodes of the pair of circuit members in the connection structure may be composed of at least one material selected from the group consisting of gold, silver, tin, platinum-group metals, aluminum, titanium, molybdenum, chromium, indium-tin oxide (ITO) and indium-zinc oxide (IZO). In the connection structure described above, a surface of at least one of the pair of circuit members may be subjected to coating or adhesion treatment with at least one material selected from the group consisting of silicon nitride, silicone compounds and polyimide resins.

The invention also provides a connection method for a circuit member comprising a step of situating the circuit connection material of the invention between two circuit members having circuit electrodes formed thereon and situated with their circuit electrodes facing each other, and carrying out heat-pressing for electrical connection between the circuit electrodes. Since this connection method employs a circuit connection material according to the invention, it is possible to guarantee satisfactory electrical connection and long-term connection reliability.

### Effect of the Invention

According to the invention it is possible to provide a circuit connection material that can allows satisfactory electrical connection to be established between opposing circuit electrodes even if the surfaces of the circuit electrodes to be connected are flat and/or oxide films readily form on the circuit electrodes, while also sufficiently increasing long-term reliability of electrical characteristics between circuit electrodes, as well as a connection structure for a circuit member employing the same, and a connection method for a circuit member used to obtain the same.

### Brief Description of the Drawings

Fig. 1 is a cross-sectional view showing an embodiment of a connection structure for a circuit member employing a circuit connection material according to the invention.
Fig. 2 is a cross-sectional view showing various forms of conductive particles composing a circuit connection material of the invention.

### Explanation of Symbols

1: Connection structure for a circuit member, 10: circuit connection material, 11: adhesive component (adhesive composition), 12: conductive particles, 14: protrusion (protrusion), 21: core, 21 a: nucleus, 21b: protrusion, 22: metal layer, 30: first circuit member, 31: circuit board (first circuit board), 31a: main side, 32: circuit electrode (first circuit electrode), 40: second circuit member, 41: circuit board (second circuit board), 41a: main side, 42: circuit electrode (second circuit electrode), T1: first circuit electrode recess due to conductive particle, T2: second circuit electrode recess due to conductive particle, H: height of conductive particle protrusions, S: distance between adjacent protrusions.

### Best Mode for Carrying Out the Invention

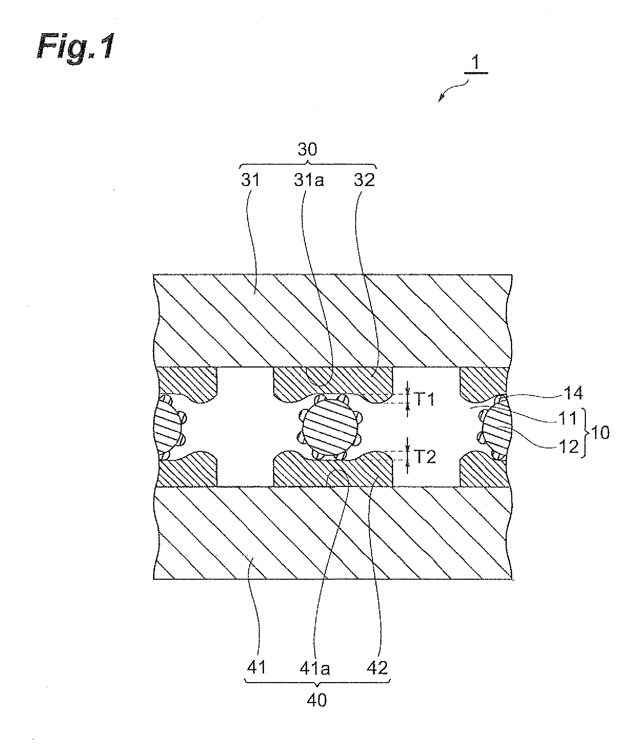

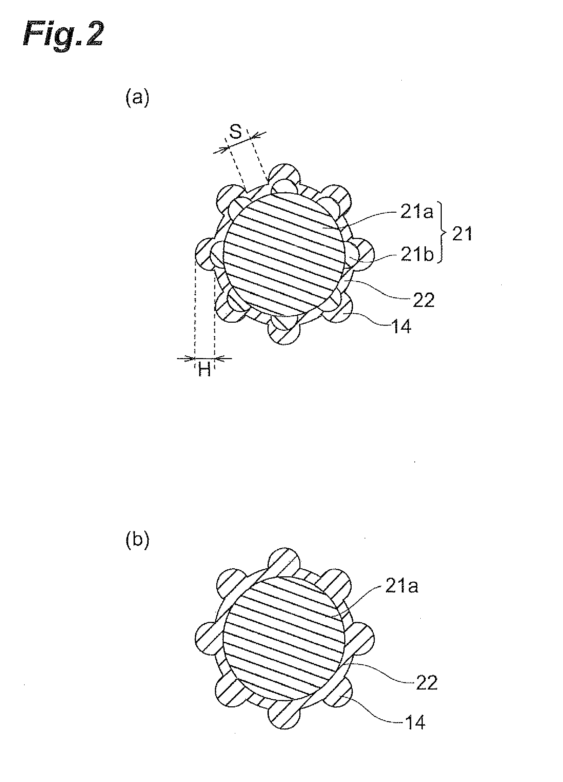

Preferred embodiments of the invention will now be explained in detail, with reference to Figs. 1 and 2. Throughout the explanation of the drawings, corresponding elements will be referred to by like reference numerals and will be explained only once. For convenience of illustration, the dimensional proportions in the drawings may not match those explained in the text.

Fig. 1 is a simplified cross-sectional view showing an embodiment of a connection structure for a circuit member employing a circuit connection material according to the invention. The connection structure for a circuit member 1 of this embodiment comprises a first circuit member 30 and a second circuit member 40 which are mutually opposing, and a circuit connection material 10 which is formed between the first circuit member 30 and second circuit member 40 and connects them.

The first circuit member 30 comprises a circuit board (first circuit board) 31, and a circuit electrode (first circuit electrode) 32 formed on the main side 31a of the circuit board 31. The second circuit member 40 comprises a circuit board 41 and a circuit electrode (second circuit electrode) 42 formed on the main side 41a of the circuit board 41.

The surfaces of the circuit electrodes 32, 42 on the circuit boards 31, 41 are flat. The phrase "the surfaces of the circuit electrodes ... are flat" used here means that the sizes of the irregularities on the surfaces of the circuit electrodes are sufficiently small, and preferably the irregularities on the surfaces are not greater than 20 nm.

The thickness of the circuit electrodes 32, 42 is preferably at least 50 nm. If the thickness is less than 50 nm, the protrusions 14 on the surface sides of the conductive particles 12 in the circuit connection material will penetrate the circuit electrodes 32, 42 during pressure bonding, potentially contacting the circuit boards 31, 41. This will tend to reduce the contact area between the circuit electrodes 32, 42 and conductive particles 12, thereby increasing the connection resistance. The thickness of the circuit electrodes 32, 42 is preferably not greater than 1000 nm and more preferably not greater than 500 nm, from the viewpoint of production cost.

The material for the circuit electrodes 32, 42 may be an Au, Ag, Sn or Pt-group metal (for example, ruthenium, rhodium, palladium, osmium, iridium or platinum) or ITO, IZO, Al, Cr, Mo, Ti or the like, but the material for the circuit electrodes 32, 42 is most preferably ITO or IZO for more satisfactory electrical connection and a more notable effect of the invention. The circuit electrodes 32, 42 may be composed entirely of the aforementioned material, or only the outermost layer alone may be composed of the material.

The material for the circuit boards 31, 41 is not particularly restricted, but will normally be an organic insulating material, glass or silicon.

As specific examples for the first circuit member 30 and second circuit member 40 there may be mentioned chip parts such as semiconductor chips (IC chips), resistor chips and condenser chips, and boards such as tape carrier packages (TCP), flexible printed circuits (FPC), printed circuit boards and glass panels. The circuit members 30, 40 will normally comprise a plurality of circuit electrodes (circuit terminals) 32, 42 (or one in some cases). The manner of connection in the connection structure for a circuit member 1 may be connection between an IC chip and a chip-mounting board, connection between electrical circuits, or connection between a COG-mounted or COF-mounted IC chip and a glass panel or flexible tape. At least one of the first and second circuit members 30, 40 is preferably an IC chip.

While the connection structure for a circuit member 1 of this embodiment is not provided with an insulating layer, an insulating layer may be further provided between the first circuit electrode 32 and circuit board 31 of the first circuit member 30, and an insulating layer may be further provided between the second circuit electrode 42 and circuit board 41 of the second circuit member 40.

The insulating layers are not particularly restricted so long as they are composed of insulating materials, but for most purposes they may be made of organic insulating materials, silicon dioxide or silicon nitride. In particular, the surface of at least one of the first and second circuit members 30, 40 is preferably subjected to coating or adhesion treatment with at least one material selected from the group consisting of silicon nitride, silicone compounds and polyimide resins. The circuit connection material 10 described above exhibits particularly satisfactory bonding strength for such circuit members 30, 40.

The circuit connection material 10 comprises an adhesive component (adhesive composition) 11 with an insulating property, and conductive particles 12. The conductive particles 12, which are explained in detail below, have protrusions 14 on the surface sides as shown in Fig. 2(a)-(b).

In the connection structure for a circuit member 1, the opposing first circuit electrode 32 and second circuit electrode 42 are electrically connected via a conductive particle 12. That is, the conductive particle 12 directly connects the circuit electrodes 32, 42. Specifically, the protrusions 14 of the conductive particle 12 penetrate the adhesive component (adhesive composition) 11 and contact with the first circuit electrode 32 and second circuit electrode 42.

This adequately reduces the connection resistance between the circuit electrodes 32, 42, allowing satisfactory electrical connection to be established between the circuit electrodes 32, 42. Consequently, smooth current flow can be achieved between the first and second circuit electrodes 32, 42, to allow the function of the circuit to be adequately exhibited.

Some of the protrusions 14, among the protrusions 14 on the conductive particles 12, are preferably embedded in the first circuit electrode 32 or second circuit electrode 42 so that recesses T1, T2 are formed. This can further increase the contact area between the circuit electrodes 32, 42 and the protrusions 14 of the conductive particle 12, thus further lowering the connection resistance.

In the connection structure for a circuit member 1, the surface area of either or both the first circuit electrode 32 and second circuit electrode 42 is preferably not greater than 3000 µm², and the average number of conductive particles between the first circuit electrode 32 and second circuit electrode 42 is preferably 15 or greater. The average number of conductive particles is the average value for the number of conductive particles per one circuit electrode. This restriction allows the connection resistance between the opposing circuit electrodes 32, 42 to be adequately reduced.

The circuit-connecting member 10 will now be explained in detail. The circuit-connecting member 10 is in the form of a film and as mentioned above, it is obtained by curing a circuit connection material containing an adhesive composition and conductive particles 12 with protrusions 14 on the surface side.

### (Conductive particles)

The construction of the conductive particles 12 as a component of the circuit-connecting member 10 of the invention will now be explained in detail. Fig. 2 is a pair of cross-sectional views showing different forms of a conductive particle in a circuit convection material of the invention. As shown in Fig. 2(a), the conductive particle 12 is composed of a particle (particle body) with a conductive property and multiple protrusions 14 formed on the surface of the particle. The multiple protrusions 14 are composed of a conductive metal. The conductive particle 12 shown in Fig. 2(a) is composed of a core 21 and a metal layer 22 formed on the surface of the core 21. The core 21 is composed of a nucleus 21 a and protrusions 21b formed on the surface of the nucleus 21a, and the metal layer 22 has multiple protrusions 14 on the surface side. The metal layer 22 covers the core 21 and protrudes out at locations corresponding to the protrusions 21b, with these protruding sections forming the protrusions 14.

From the viewpoint of achieving high connection reliability, the material of the core 21 is preferably a material that adequately follows the increase in spacing between the circuit electrodes 32, 42 after connection between the circuit electrodes 32, 42. The resistance value at the joint may increase if the core 21 cannot adequately follow the increase in spacing between the circuit electrodes 32, 42 that occurs with fluctuations in temperature. From the viewpoint of effectively preventing such increase in the resistance value, and also from the viewpoint of lowering cost and obtaining a wider elastic deformation range for dimensional change during thermal expansion or pressure bonding compared to a core made of metal, the core 21 is preferably one that is made of an organic polymer compound.

The conductive particles 12 have a compression modulus, at 20% compressive deformation of the particle diameter, of preferably 100-800 kgf/mm² and more preferably 400-700 kgf/mm². If the compression modulus at 20% compressive deformation of the particle diameter is less than 100 kgf/mm², the outermost layers of the conductive particles 12 will not easily be embedded in the circuit electrode, thus undesirably increasing the electrical resistance at the joint. On the other hand, if the compression modulus exceeds 800 kgf/mm² the conductive particles 12 may not sufficiently deform into a flat shape when the opposing circuit electrodes 32, 42 are pressed. The contact area with the circuit electrodes 32, 42 will therefore be insufficient and the electrical resistance at the joint will be increased. Conductive particles 12 with insufficient deformation are also undesirable because they cannot adequately follow the increase in spacing between the circuit electrodes 32, 42 that occurs with fluctuations in temperature and the like, and because the electrical resistance after connection is notably increased.

The organic polymer compound composing the nucleus 21a of the core 21 may be, for example, an acrylic resin, styrene resin, benzoguanamine resin, silicone resin, polybutadiene resin, or a copolymer of the foregoing, and their crosslinked forms may also be used. The mean particle size of the nucleus 21a of the core 21 may be appropriately designed according to the purpose of use, but it is preferably 1-10 µm, more preferably 2-8 µm and even more preferably 3-5 µm. If the mean particle size is less than 1 µm, secondary aggregation of the particles will tend to occur, resulting in an insufficient insulating property between the adjacent circuits. If the mean particle size is greater than 10 µm, on the other hand, the increased size will also tend to result in an insufficient insulating property between adjacent circuits.

The organic polymer compound composing the protrusions 21b of the core 21 may also be, for example, an acrylic resin, styrene resin, benzoguanamine resin, silicone resin, polybutadiene resin, or a copolymer of the foregoing, and their crosslinked forms may also be used. The organic polymer compound forming the protrusions 21b may be the same as or different from the organic polymer compound forming the nucleus 21a.

The core 21 may be formed by adsorbing numerous protrusions 21 b with smaller diameters than the nucleus 21a onto the surface of the nucleus 21a. The method of adsorbing the protrusions 21b onto the surface of the nucleus 21a may involve, for example, surface-treating one or both particles with a dilute solution of a coupling agent such as silane, aluminum or titanium and an adhesive, and then mixing them to cause their adhesion.

As examples for the material of the metal layer 22 there may be mentioned Cu, Ni or Ni alloy, Ag or Ag alloy and the like, with examples of nickel alloys including Ni-B, Ni-W, Ni-W-Co, Ni-Fe and Ni-Cr. Nickel and nickel alloys are particularly preferred because they are hard and are easily embedded in the circuit electrodes 32, 42. The metal layer 22 may be formed by plating such metals onto the core 21 by an electroless plating method. Electroless plating methods are generally categorized as either batch or continuous dropping methods, and the metal layer 22 may be formed by either type.

The film thickness (plating film thickness) of the metal layer 22 is preferably 65-125 nm, more preferably 75-100 nm and even more preferably 80-90 nm. A metal layer 22 thickness within this range can result in even more satisfactory connection resistance between the circuit electrodes 32, 42. With a metal layer 22 thickness of less than 65 nm, the small thickness will tend to increase the connection resistance, while a thickness of greater than 125 nm will tend to cause aggregation between the conductive particles 12 during plating, resulting in shorting between adjacent circuit electrodes 32, 42. Throughout the present specification, the thickness of the metal layer 22 of the conductive particles 12 refers to the thickness at the sections of the metal layer lacking the protrusions 21b, and it can be measured using an electron microscope.

The heights H of the protrusions 14 of the conductive particles 12 are preferably 65-1000 nm, more preferably 65-500 nm and even more preferably 100-500 nm.

The distance S between adjacent protrusions 14 is preferably not greater than 1000 nm and more preferably not greater than 500 nm. The distance S between adjacent protrusions 14 is preferably at least 50 nm, so that the adhesive composition does not permeate between the conductive particles 12 and circuit electrodes 32, 42 and contact is established between the conductive particles 12 and circuit electrodes 32, 42. The heights H of the protrusions 14 of the conductive particles 12 and the distance S between adjacent protrusions 14 can be measured using an electron microscope.

Each conductive particle 12 may have the core 21 composed entirely of the nucleus 21 a, as shown in Fig. 2(b). In other words, the protrusions 21b on the conductive particle 12 shown in Fig. 2(a) may be absent. Such a conductive particle 12 can be obtained by metal plating the surface of the core 21 to form a metal layer 22 on the surface of the core 21.

A plating method for formation of the protrusions 14 will now be explained. The protrusions 14 can be formed on the metal layer 22 by varying the thickness of the metal layer 22 via different plating conditions during the plating reaction for metal plating. Different plating conditions can be created by, for example, adding a plating solution with a higher concentration than the initially used plating solution to create a non-uniform plating solution concentration. The pH of the plating solution can also be adjusted, for example to a pH of 6 for a nickel plating solution, to obtain a metal layer 22 with a nodular metal layer, i.e. protrusions 14 (Mochizuki et al., Hyoumen Gijutsu, Vol. 48, No. 4, p.429-432, 1997). Also, a smooth metal layer (coating) can be obtained when glycine is used as a complexing agent to promote plating bath stability, while a nodular coating, i.e. a metal layer 22 with protrusions 14, can be obtained when tartaric acid or DL-malic acid is used (Ogiwara et al., Amorphous Platings, Vol.36, p.35-37, 1994; Ogiwara et al., Institute of Circuit Mounting, Vol.10, No. 3, p.148-152, 1995).

Also, the percentage of particles having the metal layer 22 completely separate from the core 21, among 250,000 of the conductive particles 12, is preferably less than 5%, more preferably less than 1% and even more preferably less than 0.1%. Conduction between the circuit electrodes 32, 42 can be ensured if the proportion of particles with the metal layer 22 completely separated from the core 21 is within this range. If the proportion of particles with the metal layer 22 completely separated from the core 21 is 5% or greater, the presence of the particles not contributing to conduction on the electrode will tend to increase the connection resistance.

The conductive particles 12 according to the invention may have their cores 21 partially exposed. From the viewpoint of connection reliability, the coverage factor of the metal layer 22 is preferably at least 70% and more preferably 80-100%. A metal layer 22 coverage factor within this range can result in even more satisfactory connection resistance between the circuit electrodes 32, 42. With a metal layer 22 coverage factor of less than 70%, the reduced conduction area on the surfaces of the conductive particles 12 will tend to result in increased connection resistance.

The metal layer 22 may be composed of a single metal layer or a plurality of metal layers.

### (Adhesive composition)

The adhesive component (adhesive composition) 11 in the aforementioned circuit connection material 10 will now be described in detail. The adhesive component (adhesive composition) 11 in the circuit connection material 10 exhibits an adhesive property, and hardens upon curing treatment of the first and second circuit members 30, 40.

The adhesive composition preferably comprises a film-forming material, an epoxy resin and a latent curing agent. This will allow the effect of the invention to be exhibited more reliably.

The film-forming material used for the invention may be a phenoxy resin, polyvinyl formal resin, polystyrene resin, polyvinyl butyral resin, polyester resin, polyamide resin, xylene resin, polyurethane resin, or the like. A film-forming material is a material which, when a liquid substance is solidified as a structural composition and formed into a film, is easily handleable as a film and confers mechanical properties that prevent tearing, cracking or sticking, thereby permitting it to be handled as a film under ordinary conditions (ordinary temperature and pressure).

Phenoxy resins are particularly preferred among film-forming materials because of their excellent adhesion, compatibility, heat resistance and mechanical strength. A phenoxy resin is a resin obtained either by reacting a bifunctional phenol with an epihalohydrin to a high molecular weight, or by polyaddition of a bifunctional epoxy resin and a bifunctional phenol. Specifically, it may be obtained by, for example, reacting 1 mol of a bifunctional phenol with 0.985-1.015 mol of an epihalohydrin in a non-reactive solvent at a temperature of 40-120°C, in the presence of an alkali metal hydroxide.

From the viewpoint of resin mechanical properties and thermal properties, particularly preferred phenoxy resins are those obtained by polyaddition reaction of a bifunctional epoxy resin and a bifunctional phenol at an epoxy group/phenol hydroxyl group equivalent ratio of 1/0.9-1/1.1, with heating to 50-200°C and with a reaction solid content of not greater than 50 parts by mass, in an amide-based, ether-based, ketone-based, lactone-based or alcohol-based organic solvent with a boiling point of 120°C or higher, in the presence of a catalyst such as an alkali metal compound, organic phosphorus-based compound, cyclic amine-based compound or the like.

As bifunctional epoxy resins there may be mentioned bisphenol A-type epoxy resins, bisphenol F-type epoxy resins, bisphenol AD-type epoxy resins, bisphenol S-type epoxy resins, biphenyldiglycidyl ethers, methyl-substituted biphenyldiglycidyl ethers and the like. Bifunctional phenols have two phenolic hydroxyl groups. As examples of bifunctional phenols there may be mentioned hydroquinones, and bisphenols such as bisphenol A, bisphenol F, bisphenol AD, bisphenol S, bisphenolfluorene, methyl-substituted bisphenolfluorene, dihydroxybiphenyl and methyl-substituted dihydroxybiphenyl. The phenoxy resin may be modified with radical-polymerizing functional groups or with other reactive compounds (for example, epoxy-modified). A phenoxy resin may be used alone, or two or more different ones may be used in combination.

As examples of epoxy resins to be used for the invention there may be mentioned bisphenol-type epoxy resins derived from epichlorohydrin and bisphenol A, F AD or the like; epoxy-novolac resins derived from epichlorohydrin and phenol-novolac or cresol-novolac; naphthalene-based epoxy resins having naphthalene ring-containing backbones, and glycidylamine-type epoxy resins, glycidyl ether-type epoxy resins and epoxy compounds with two or more glycidyl groups in a biphenyl or alicyclic compound, and any of these may be used alone or in combinations of two or more. These epoxy resins are preferably high purity products with the impurity ion (Na⁺, Cl⁻, etc.) and hydrolyzable chlorine content reduced to not greater than 300 ppm, in order to prevent electron migration.

The latent curing agent used for the invention may be any one capable of curing the epoxy resin, and as such latent curing agents there may be mentioned anionic polymerizable catalyst-type curing agents, cationic polymerizable catalyst-type curing agents and polyaddition-type curing agents. Any of these may be used alone or in mixtures of two or more. Preferred among these are anionic and cationic polymerizable catalyst-type curing agents since they have excellent fast-curing properties and do not require special consideration in regard to chemical equivalents.

As anionic or cationic polymerizable catalyst-type curing agents there may be mentioned imidazole-based agents, hydrazide-based agents, boron trifluoride-amine complexes, sulfonium salts, amineimides, diaminomaleonitrile, melamine and its derivatives, polyamine salts, dicyandiamide and the like, and modified forms of the foregoing may also be used. As polyaddition-type curing agents there may be mentioned polyamines, polymercaptanes, polyphenols, acid anhydrides and the like.

When a tertiary amine or imidazole is added as an anionic polymerizable catalyst-type curing agent, the epoxy resin is cured by heating at a moderate temperature of about 160°C-200°C for from several tens of seconds to several hours. This is preferred because it lengthens the pot life.

Preferred examples of cationic polymerizable catalyst-type curing agents include photosensitive onium salts that cure epoxy resins under energy ray exposure (mainly aromatic diazonium salts, aromatic sulfonium salts and the like). Aliphatic sulfonium salts are among those that are activated and cure epoxy resins by heat instead of energy ray exposure. Such curing agents are preferred because of their fast-curing properties.

Microencapsulated forms obtained by covering these latent curing agents with polyurethane-based or polyester-based polymer substances or inorganic materials such as metal thin-films of nickel or copper, or calcium silicate, are preferred as they can lengthen the pot life.

The circuit connection material 10 of this embodiment may also be a polymer or copolymer of at least one monomer component selected from among acrylic acid, acrylic acid esters, methacrylic acid esters and acrylonitrile, preferably in combination with glycidyl ether group-containing glycidyl acrylates or glycidyl methacrylate-containing copolymer-based acrylic rubber, in order to obtain excellent stress relaxation. The molecular weight (polystyrene-based weight-average molecular weight according to size exclusion chromatography) of the acrylic rubber is preferably at least 200,000 from the viewpoint of increasing the cohesion of the adhesive.

The content of the conductive particles 12 is preferably 0.1-30 parts by volume with respect to 100 parts by volume of the adhesive composition, and the content may be selected depending on the purpose of use. From the viewpoint of preventing shorting between the circuit electrodes 32, 42 by excess conductive particles 12, the content of the conductive particles 12 is more preferably 0.1-10 parts by volume.

The circuit connection material 10 of this embodiment may also contain rubber fine particles or a filler, softening agent, accelerator, age inhibitor, flame retardant, pigment, thixotropic agent, coupling agent, phenol resin, melamine resin, isocyanate or the like.

The rubber fine particles may have a mean particle size of up to twice the mean particle size of the conductive particles 12, and they may have a storage elastic modulus of up to 1/2 the storage elastic modulus of the conductive particles 12 and adhesive composition at room temperature (25°C). Fine particles wherein the material of the rubber fine particles is silicone, an acrylic emulsion, SBR, NBR or polybutadiene rubber are particularly suitable, either alone or in combinations of two or more types. Three-dimensionally crosslinked rubber fine particles have excellent solvent resistance and readily disperse in the adhesive composition.

A filler is preferably included to improve the connection reliability. Any filler with a maximum diameter less than the particle size of the conductive particles 12 may be used, because a filler particle size that is larger than the particle size of the conductive particles 12 may interfere with flattening of the conductive particles. The content of the filler is preferably in the range of 5-60 parts by volume (with respect to 100 parts by volume as the resin component of the adhesive composition). A content of greater than 60 parts by volume may saturate the effect of improved reliability, while a content of less than 5 parts by volume will result in a reduced effect of addition.

Preferred coupling agents, from the viewpoint of adhesion, are compounds containing one or more groups selected from among ketimine, vinyl, acrylic, amino, epoxy and isocyanate groups. As specific examples of silane coupling agents with amino groups there may be mentioned N-β(aminoethyl)γ-arninopropyltrimethoxysilane, N-β(aminoethyl)γ-aminopropylmethyldimethoxysilane, γ-aminopropyltriethoxysilane and N-phenyl-γ-aminopropyltrimethoxysilane. As ketimine-containing silane coupling agents there may be mentioned those obtained by reaction of ketone compounds such as acetone, methyl ethyl ketone and methyl isobutyl ketone with the aforementioned amino group-containing silane coupling agents.

A film-like circuit connection material may be formed by coating a support (a PET (polyethylene terephthalate) film or the like) with the circuit connection material using a coating apparatus (not shown), and drying it with hot air for a prescribed time period.

### [Process for production of connection structure for a circuit member]

A process for producing the connection structure for a circuit member 1 described above will now be explained.

First, there are prepared a first circuit member 30, a second circuit member 40, and a circuit connection material. The circuit connection material may be, for example, a circuit connection material shaped into a film (hereinafter referred to as "film-like circuit connection material"). The film-like circuit connection material comprises an adhesive composition which hardens upon curing treatment of the first circuit member 30 and second circuit member 40, and conductive particles 12. The thickness of the film-like circuit connection material is preferably 5-50 µm. If the thickness of the film-like circuit connection material is less than 5 µm, the film-like circuit connection material may fail to sufficiently fill the area between the first and second circuit electrodes 32, 42. If the thickness is greater than 50 µm, on the other hand, it may be difficult to ensure conduction between the first and second circuit electrodes 32, 42.

The film-like circuit connection material is then placed on the first circuit member 30. The second circuit member 40 is placed on the film-like circuit connection material with the first circuit electrode 32 and second circuit electrode 42 facing each other. This situates the film-like circuit connection material between the first circuit member 30 and second circuit member 40. The film-like circuit connection material is easy to manage since it is in the form of a film. Thus, the film-like circuit connection material can be easily situated between the first circuit member 30 and second circuit member 40 when they are connected, thus facilitating the connection operation for the first circuit member 30 and second circuit member 40.

Next, the film-like circuit connection material is heated and pressed through the first circuit member 30 and second circuit member 40 for curing treatment to form a circuit connection material 10 between the first and second circuit members 30, 40. The curing treatment may be carried out by an ordinary method, which may be appropriately selected depending on the adhesive composition. Since the Ni as the outermost layer of the conductive particles 12 in the circuit connection material is harder than the conventional Au, the protrusions 14 will become embedded more deeply than conventional conductive particles in the outermost layer of the first or second circuit electrode 32, 42, and therefore the contact area between the conductive particles and circuit electrodes will be increased. In addition, if the thickness of the first or second circuit electrode 32, 42 is at least 50 nm, the protrusions of the conductive particles will penetrate into the circuit electrodes, thus helping to prevent reduction in the contact area. Curing treatment of the circuit connection material results in curing of the adhesive composition, with high adhesive strength between the first circuit member 30 and second circuit member 40, so that firm contact between the conductive particles 12 and the first and second circuit electrodes 32, 42 can be maintained for prolonged periods.

It is thus possible to sufficiently lower connection resistance between the opposing first and second circuit electrodes 32, 42 regardless of whether or not irregularities are present on the surface of the first and/or second circuit electrode 32, 42, in order to achieve satisfactory electrical connection between the first circuit electrode 32 and second circuit electrode 42 while adequately increasing the long-term reliability of electrical characteristics between the first and second circuit electrodes 32, 42.

Incidentally, although the connection structure for a circuit member 1 of this embodiment is fabricated using a film-like circuit connection material, a circuit connection material before shaped into a film may be used instead of a film-like circuit connection material. In this case as well, dissolving the circuit connection material in a solvent and coating and drying the solution on either the first circuit member 30 or second circuit member 40 allows it to be situated between the first and second circuit members 30, 40.

The embodiments described above are preferred embodiments of the invention, but the invention is not limited thereto. The invention may also be applied in a variety of modifications so long as the gist thereof is maintained.

### Examples

The content of the present invention will now be explained in greater detail by examples, with the understanding that the invention is not limited to these examples.

### [Preparation of conductive particles]

### (Formation of conductive particles No. 1)

Cores with particle sizes of approximately 3 µm were obtained by suspension polymerization with different mixing ratios of tetramethylolmethane tetraacrylate, divinylbenzene and styrene monomer, using benzoyl peroxide as the polymerization initiator, and classifying the obtained polymer. The charging mass of the plating solution and the treatment temperature and time were adjusted during electroless Ni plating treatment on the surfaces of the obtained cores to vary the plating thickness, in order to form Ni plating protrusions on the core surfaces and obtain conductive particles No. 1 having protrusions and having the target Ni film thickness of 90 nm.

An H-100 microhardness tester by Fischer Instruments, K.K. was used to measure the compression modulus of the conductive particles No. 1, and as a result the compression modulus at 20% compressive deformation of the particle diameters of the particles was found to be 650 kgf/mm². The conductive particles No. 1 were also observed with an electron microscope (S-800 by Hitachi, Ltd.), and upon measurement of the heights of the protrusions and the distance between adjacent protrusions, the protrusion height was 100 nm and the distance between adjacent protrusions was 500 nm.

### (Formation of conductive particles No. 2)

The conductive particles No. 1 were subjected to further substitution plating with Au to 20 nm, forming an Au layer with numerous protrusions, to obtain conductive particles No. 2. An H-100 microhardness tester by Fischer Instruments, K.K. was used to measure the compression modulus of the conductive particles No. 2, and as a result the compression modulus at 20% compressive deformation of the particle diameters of the particles was found to be 650 kgf/mm². The conductive particles No. 2 were also observed with an electron microscope (S-800 by Hitachi, Ltd.), and upon measurement of the heights of the protrusions and the distance between adjacent protrusions, the protrusion height was 100 nm and the distance between adjacent protrusions was 500 nm.

### (Formation of conductive particles No. 3)

The charging mass of the plating solution and the treatment temperature and time were adjusted during electroless Ni plating treatment on the surfaces of cores having a particle size of about 3 µm and having a compression modulus different from the cores of the conductive particles No. 1, to vary the plating thickness, in order to form Ni plating protrusions on the core surfaces and obtain conductive particles No. 3 having protrusions and having the target Ni film thickness of 90 nm. An H-100 microhardness tester by Fischer Instruments, K.K. was used to measure the compression modulus of the conductive particles No. 3, and as a result the compression modulus at 20% compressive deformation of the particle diameters of the particles was found to be 400 kgf/mm². The conductive particles No. 3 were also observed with an electron microscope (S-800 by Hitachi, Ltd.), and upon measurement of the heights of the protrusions and the distance between adjacent protrusions, the protrusion height was 100 nm and the distance between adjacent protrusions was 500 nm.

### (Formation of conductive particles No. 4)

The charging mass of the plating solution and the treatment temperature and time were adjusted during electroless Ni plating treatment on the surfaces of cores having a particle size of about 3 µm and having a compression modulus different from the cores of the conductive particles No. 1, to vary the plating thickness, in order to form Ni plating protrusions on the core surfaces and obtain conductive particles No. 4 having protrusions and having the target Ni film thickness of 90 nm. An H-100 microhardness tester by Fischer Instruments, K.K. was used to measure the compression modulus of the conductive particles No. 4, and as a result the compression modulus at 20% compressive deformation of the particle diameters of the particles was found to be 90 kgf/mm². The conductive particles No. 4 were also observed with an electron microscope (S-800 by Hitachi, Ltd.), and upon measurement of the heights of the protrusions and the distance between adjacent protrusions, the protrusion height was 100 nm and the distance between adjacent protrusions was 500 nm.

### [Fabrication of circuit connection material]

### (Fabrication of circuit connection material A)

A phenoxy resin was synthesized from a bisphenol A-type epoxy resin and 9,9'-bis(4-hydroxyphenyl)fluorene. A 50 g portion of this resin was dissolved in a mixed solvent of toluene (boiling point of 110.6°C, SP value = 8.90)/ethyl acetate (boiling point of 77.1°C, SP value =9.10) in a mass ratio of 50:50, to obtain a resin solution with a solid content of 40 % by mass.

A liquid curing agent-containing epoxy resin (epoxy equivalent: 202) was also prepared containing a microencapsulated latent curing agent (microencapsulated amine-based curing agent), a bisphenol F-type epoxy resin and a naphthalene-type epoxy resin in a mass ratio of 34:49:17.

The materials were mixed with a phenoxy resin:curing agent-containing epoxy resin solid mass ratio of 40:60, to prepare an adhesive composition-containing solution. Conductive particles No. 1 were further added to the obtained adhesive composition-containing solution at 5 vol% with respect to the resin component and dispersed therein to prepare a circuit connection material-containing solution.

A coating apparatus was used to coat the circuit connection material-containing solution onto a 50 µm-thick PET film that had been surface-treated on one side, and the coating was dried with hot air at 70°C for 5 minutes to form a film-like circuit connection material A to a thickness of 20 µm on the PET film.

### (Fabrication of circuit connection material B)

A 50 g portion of a bisphenol A-type phenoxy resin was dissolved in a mixed solvent comprising toluene and ethyl acetate in a mass ratio of 50:50 to form a first solution with a solid content of 40 % by mass, while a 50 g portion of a bisphenol A/T copolymer-type phenoxy resin was dissolved in a mixed solvent comprising toluene and ethyl acetate in a mass ratio of 50:50 to form a second solution with a solid content of 45 % by mass.

The first and second solutions were combined, and a liquid epoxy resin (epoxy equivalents: 185) was further added to the mixture. The bisphenol A-type phenoxy resin and bisphenol A/F copolymer-type phenoxy resin and liquid epoxy were combined in a solid mass ratio of 30:30:40 to produce an adhesive composition-containing solution. Conductive particles No. 1 were further added to the obtained adhesive composition-containing solution at 5 vol% with respect to the resin component and dispersed therein, and then 4.8 g of an aromatic sulfonium salt was added as a latent curing agent to prepare a circuit connection material-containing solution.

A coating apparatus was used to coat the circuit connection material-containing solution onto a 50 µm-thick PET film that had been surface-treated on one side, and the coating was dried with hot air at 70°C for 5 minutes to form a film-like circuit connection material B to a thickness of 20 µm on the PET film.

### (Fabrication of circuit connection material C)

Circuit connection material C was obtained by the same procedure as for circuit connection material A, except that conductive particles No. 2 were used instead of the conductive particles No. 1 in circuit connection material A.

### (Fabrication of circuit connection material D)

Circuit connection material D was obtained by the same procedure as for circuit connection material B, except that conductive particles No. 2 were used instead of the conductive particles No. 1 in circuit connection material B.

### (Fabrication of circuit connection material E)

Circuit connection material E was obtained by the same procedure as for circuit connection material A, except that conductive particles No. 3 were used instead of the conductive particles No. 1 in circuit connection material A.

### (Fabrication of circuit connection material F)

Circuit connection material F was obtained by the same procedure as for circuit connection material B, except that conductive particles No. 3 were used instead of the conductive particles No. 1 in circuit connection material B.

### (Fabrication of circuit connection material G)

Circuit connection material G was obtained by the same procedure as for circuit connection material A, except that conductive particles No. 4 were used instead of the conductive particles No. 1 in circuit connection material A.

### (Fabrication of circuit connection material H)

Circuit connection material H was obtained by the same procedure as for circuit connection material B, except that conductive particles No. 4 were used instead of the conductive particles No. 1 in circuit connection material B.

### (Example 1)

An IC chip bearing an array of gold bumps with a bump area of 50 µm × 50 µm, a pitch of 100 µm and a height of 20 µm was prepared as a first circuit member. Next, a glass panel (thickness: 0.5 mm) was prepared comprising an ITO circuit electrode (thickness: 200 nm, surface resistance: <20 Ω) on the surface, as a second circuit member, and with the circuit electrodes worked to match the arrangement of bumps on the IC chip. Circuit connection material A cut to a prescribed size (2.5 × 30 mm) was attached onto the second circuit member, and pre-connection was established by heating and pressing at 70°C, 1.0 MPa for 5 seconds. The PET film was then released, the IC was positioned so that the film-like circuit connection material A was sandwiched by the IC and second circuit member, and the circuit of the IC and the circuit of the second circuit member were aligned. This was then sandwiched between quartz glass and a pressing head and heated and pressed from above the IC under conditions of 200°C, 100 MPa, 10 seconds for main connection between the IC and second circuit member. A connection structure for a circuit member for Example 1 was thus obtained.

### (Example 2)

An IC was prepared in the same manner as Example 1 as the first circuit member. Next, a glass panel (thickness: 0.5 mm) was prepared comprising a circuit electrode (surface resistance: <30 Ω) having a 3-layer construction of ITO (outermost layer, thickness: 100 nm)/Mo (thickness: 50 nm)/Al (thickness: 150 nm) on the surface, as a second circuit member, and with the circuit electrodes worked to match the arrangement of bumps on the IC chip. Pre-connection and main connection of the circuit connection material A were carried out in the same manner as the connection in Example 1 to obtain a connection structure for a circuit member for Example 2.

### (Example 3)

An IC was prepared in the same manner as Example 1 as the first circuit member. Next, a glass panel (thickness: 0.5 mm) was prepared comprising a circuit electrode (surface resistance: <40 Ω) having a 3-layer construction of IZO (outermost layer, thickness: 100 nm)/Mo (thickness: 50 nm)/Al (thickness: 150 nm) on the surface, as a second circuit member, and with the circuit electrodes worked to match the arrangement of bumps on the IC chip. Pre-connection and main connection of the circuit connection material A were carried out in the same manner as the connection in Example 1 to obtain a connection structure for a circuit member for Example 3.

### (Example 4)

An IC was prepared in the same manner as Example 1 as the first circuit member. Next, a glass panel (thickness: 0.5 mm) was prepared comprising an ITO circuit electrode (thickness: 200 nm, surface resistance: <20 Ω) in the same manner as Example 1, as a second circuit member. Circuit connection material B cut to a prescribed size (2.5 × 30 mm) was attached onto the second circuit member, and pre-connection was established by heating and pressing at 70°C, 1.0 MPa for 5 seconds. The PET film was then released, the IC was positioned so that the film-like circuit connection material B was sandwiched by the IC and second circuit member, and the circuit of the IC and the circuit of the second circuit member were aligned. This was then sandwiched between quartz glass and a pressing head and heated and pressed from above the IC under conditions of 160°C, 100 MPa, 10 seconds for main connection between the IC and second circuit member. A connection structure for a circuit member for Example 4 was thus obtained.

### (Example 5)

An IC was prepared in the same manner as Example 1 as the first circuit member. Next, a glass panel (thickness: 0.5 mm) was prepared comprising a circuit electrode (surface resistance: <30 Ω) with a 3-layer construction of ITO (outermost layer, thickness: 100 nm)/Mo (thickness: 50 nm)/Al (thickness: 150 nm) in the same manner as Example 2, as a second circuit member. Pre-connection and main connection of the circuit connection material B were carried out in the same manner as the connection in Example 4 to obtain a connection structure for a circuit member for Example 5.

### (Example 6)

An IC was prepared in the same manner as Example 1 as the first circuit member. Next, a glass panel (thickness: 0.5 mm) was prepared comprising a circuit electrode (surface resistance: <40 Ω) with a 3-layer construction of IZO (outermost layer, thickness: 100 nm)/Mo (thickness: 50 nm)/Al (thickness: 150 nm) in the same manner as Example 3, as a second circuit member. Pre-connection and main connection of the circuit connection material B were carried out in the same manner as the connection in Example 4 to obtain a connection structure for a circuit member for Example 6.

### (Example 7)

An IC was prepared in the same manner as Example 1 as the first circuit member. Next, a glass panel (thickness: 0.5 mm) was prepared comprising an ITO circuit electrode (thickness: 200 nm, surface resistance: <20 Ω) in the same manner as Example 1, as a second circuit member. Circuit connection material E cut to a prescribed size (2.5 × 30 mm) was attached onto the second circuit member, and pre-connection was established by heating and pressing at 70°C, 1.0 MPa for 5 seconds. The PET film was then released, the IC was positioned so that the film-like circuit connection material E was sandwiched by the IC and second circuit member, and the circuit of the IC and the circuit of the second circuit member were aligned. This was then sandwiched between quartz glass and a pressing head and heated and pressed from above the IC under conditions of 200°C, 100 MPa, 10 seconds for main connection between the IC and second circuit member. A connection structure for a circuit member for Example 7 was thus obtained.

### (Example 8)

An IC was prepared in the same manner as Example 1 as the first circuit member. Next, a glass panel (thickness: 0.5 mm) was prepared comprising a circuit electrode (surface resistance: <30 Ω) with a 3-layer construction of ITO (outermost layer, thickness: 100 nm)/Mo (thickness: 50 nm)/Al (thickness: 150 nm) in the same manner as Example 2, as a second circuit member. Pre-connection and main connection of the circuit connection material E were carried out in the same manner as the connection in Example 7 to obtain a connection structure for a circuit member for Example 8.

### (Example 9)

An IC was prepared in the same manner as Example 1 as the first circuit member. Next, a glass panel (thickness: 0.5 mm) was prepared comprising a circuit electrode (surface resistance: <40 Ω) with a 3-layer construction of IZO (outermost layer, thickness: 100 nm)/Mo (thickness: 50 nm)/Al (thickness: 150 nm) in the same manner as Example 3, as a second circuit member. Pre-connection and main connection of the circuit connection material E were carried out in the same manner as the connection in Example 7 to obtain a connection structure for a circuit member for Example 9.

### (Example 10)

An IC was prepared in the same manner as Example 1 as the first circuit member. Next, a glass panel (thickness: 0.5 mm) was prepared comprising an ITO circuit electrode (thickness: 200 nm, surface resistance: <20 Ω) in the same manner as Example 1, as a second circuit member. Circuit connection material F cut to a prescribed size (2.5 × 30 mm) was attached onto the second circuit member, and pre-connection was established by heating and pressing at 70°C, 1.0 MPa, for 5 seconds. The PET film was then released, the IC was positioned so that the film-like circuit connection material F was sandwiched by the IC and second circuit member, and the circuit of the IC and the circuit of the second circuit member were aligned. This was then sandwiched between quartz glass and a pressing head and heated and pressed from above the IC under conditions of 160°C, 100 MPa, 10 seconds for main connection between the IC and second circuit member. A connection structure for a circuit member for Example 10 was thus obtained.

### (Example 11)

An IC was prepared in the same manner as Example 1 as the first circuit member. Next, a glass panel (thickness: 0.5 mm) was prepared comprising a circuit electrode (surface resistance: <30 Ω) with a 3-layer construction of ITO (outermost layer, thickness: 100 nm)/Mo (thickness: 50 nm)/Al (thickness: 150 nm) in the same manner as Example 2, as a second circuit member. Pre-connection and main connection of the circuit connection material F were carried out in the same manner as the connection in Example 10 to obtain a connection structure for a circuit member for Example 11.

### (Example 12)

An IC was prepared in the same manner as Example 1 as the first circuit member. Next, a glass panel (thickness: 0.5 mm) was prepared comprising a circuit electrode (surface resistance: <40 Ω) with a 3-layer construction of IZO (outermost layer, thickness: 100 nm)/Mo (thickness: 50 nm)/Al (thickness: 150 nm) in the same manner as Example 3, as a second circuit member. Pre-connection and main connection of the circuit connection material F were carried out in the same manner as the connection in Example 10 to obtain a connection structure for a circuit member for Example 12.

### (Comparative Example 1)

An IC was prepared in the same manner as Example 1 as the first circuit member. Next, a glass panel (thickness: 0.5 mm) was prepared comprising an ITO circuit electrode (thickness: 200 nm, surface resistance: <20 Ω) in the same manner as Example 1, as a second circuit member. Circuit connection material C cut to a prescribed size (2.5 × 30 mm) was attached onto the second circuit member, and pre-connection was established by heating and pressing at 70°C, 1.0 MPa for 5 seconds. The PET film was then released, the IC was positioned so that the film-like circuit connection material C was sandwiched by the IC and second circuit member, and the circuit of the IC and the circuit of the second circuit member were aligned. This was then sandwiched between quartz glass and a pressing head and heated and pressed from above the IC under conditions of 200°C, 100 MPa, 10 seconds for main connection between the IC and second circuit member. A connection structure for a circuit member for Comparative Example 1 was thus obtained.

### (Comparative Example 2)

An IC was prepared in the same manner as Example 1 as the first circuit member. Next, a glass panel (thickness: 0.5 mm) was prepared comprising a circuit electrode (surface resistance: <30 Ω) with a 3-layer construction of ITO (outermost layer, thickness: 100 nm)/Mo (thickness: 50 nm)/Al (thickness: 150 nm) in the same manner as Example 2, as a second circuit member. Pre-connection and main connection of the circuit connection material C were carried out in the same manner as the connection in Comparative Example 1, to obtain a connection structure for a circuit member for Comparative Example 2.

### (Comparative Example 3)

An IC was prepared in the same manner as Example 1 as the first circuit member. Next, a glass panel (thickness: 0.5 mm) was prepared comprising a circuit electrode (surface resistance: <40 Ω) with a 3-layer construction of IZO (outermost layer, thickness: 100 nm)/Mo (thickness: 50 nm)/Al (thickness: 150 nm) in the same manner as Example 3, as a second circuit member. Pre-connection and main connection of the circuit connection material C were carried out in the same manner as the connection in Comparative Example 1, to obtain a connection structure for a circuit member for Comparative Example 3.

### (Comparative Example 4)

An IC was prepared in the same manner as Example 1 as the first circuit member. Next, a glass panel (thickness: 0.5 mm) was prepared comprising an ITO circuit electrode (thickness: 200 nm, surface resistance: <20 Ω) in the same manner as Example 1, as a second circuit member. Circuit connection material D cut to a prescribed size (2.5 × 30 mm) was attached onto the second circuit member, and pre-connection was established by heating and pressing at 70°C, 1.0 MPa for 5 seconds. The PET film was then released, the IC was positioned so that the film-like circuit connection material D was sandwiched by the IC and second circuit member, and the circuit of the IC and the circuit of the second circuit member were aligned. This was then sandwiched between quartz glass and a pressing head and heated and pressed from above the IC under conditions of 160°C, 100 MPa, 10 seconds for main connection between the IC and second circuit member. A connection structure for a circuit member for Comparative Example 4 was thus obtained.

### (Comparative Example 5)

An IC was prepared in the same manner as Example 1 as the first circuit member. Next, a glass panel (thickness: 0.5 mm) was prepared comprising a circuit electrode (surface resistance: <30 Ω) with a 3-layer construction of ITO (outermost layer, thickness: 100 nm)/Mo (thickness: 50 nm)/Al (thickness: 150 nm) in the same manner as Example 2, as a second circuit member. Pre-connection and main connection of the circuit connection material D were carried out in the same manner as the connection in Comparative Example 4, to obtain a connection structure for a circuit member for Comparative Example 5.

### (Comparative Example 6)

An IC was prepared in the same manner as Example 1 as the first circuit member. Next, a glass panel (thickness: 0.5 mm) was prepared comprising a circuit electrode (surface resistance: <40 Ω) with a 3-layer construction of IZO (outermost layer, thickness: 100 nm)/Mo (thickness: 50 nm)/Al (thickness: 150 nm) in the same manner as Example 3, as a second circuit member. Pre-connection and main connection of the circuit connection material D were carried out in the same manner as the connection in Comparative Example 4, to obtain a connection structure for a circuit member for Comparative Example 6.

### (Comparative Example 7)

An IC was prepared in the same manner as Example 1 as the first circuit member. Next, a glass panel (thickness: 0.5 mm) was prepared comprising an ITO circuit electrode (thickness: 200 nm, surface resistance: <20 Ω) in the same manner as Example 1, as a second circuit member. Circuit connection material G cut to a prescribed size (2.5 × 30 mm) was attached onto the second circuit member, and pre-connection was established by heating and pressing at 70°C, 1.0 MPa for 5 seconds. The PET film was then released, the IC was positioned so that the film-like circuit connection material G was sandwiched by the IC and second circuit member, and the circuit of the IC and the circuit of the second circuit member were aligned. This was then sandwiched between quartz glass and a pressing head and heated and pressed from above the IC under conditions of 200°C, 100 MPa, 10 seconds for main connection between the IC and second circuit member. A connection structure for a circuit member for Comparative Example 7 was thus obtained.

### (Comparative Example 8)

An IC was prepared in the same manner as Example 1 as the first circuit member. Next, a glass panel (thickness: 0.5 mm) was prepared comprising a circuit electrode (surface resistance: <30 Ω) with a 3-layer construction of ITO (outermost layer, thickness: 100 nm)/Mo (thickness: 50 nm)/Al (thickness: 150 nm) in the same manner as Example 2, as a second circuit member. Pre-connection and main connection of the circuit connection material G were carried out in the same manner as the connection in Comparative Example 7, to obtain a connection structure for a circuit member for Comparative Example 8.

### (Comparative Example 9)

An IC was prepared in the same manner as Example 1 as the first circuit member. Next, a glass panel (thickness: 0.5 mm) was prepared comprising a circuit electrode (surface resistance: <40 Ω) with a 3-layer construction of IZO (outermost layer, thickness: 100 nm)/Mo (thickness: 50 nm)/Al (thickness: 150 nm) in the same manner as Example 3, as a second circuit member. Pre-connection and main connection of the circuit connection material G were carried out in the same manner as the connection in Comparative Example 7, to obtain a connection structure for a circuit member for Comparative Example 9.

### (Comparative Example 10)

An IC was prepared in the same manner as Example 1 as the first circuit member. Next, a glass panel (thickness: 0.5 mm) was prepared comprising an ITO circuit electrode (thickness: 200 nm, surface resistance: <20 Ω) in the same manner as Example 1, as a second circuit member. Circuit connection material H cut to a prescribed size (2.5 × 30 mm) was attached onto the second circuit member, and pre-connection was established by heating and pressing at 70°C, 1.0 MPa for 5 seconds. The PET film was then released, the IC was positioned so that the film-like circuit connection material H was sandwiched by the IC and second circuit member, and the circuit of the IC and the circuit of the second circuit member were aligned. This was then sandwiched between quartz glass and a pressing head and heated and pressed from above the IC under conditions of 160°C, 100 MPa, 10 seconds for main connection between the IC and second circuit member. A connection structure for a circuit member for Comparative Example 10 was thus obtained.

### (Comparative Example 11)

An IC was prepared in the same manner as Example 1 as the first circuit member. Next, a glass panel (thickness: 0.5 mm) was prepared comprising a circuit electrode (surface resistance: <30 Ω) with a 3-layer construction of ITO (outermost layer, thickness: 100 nm)/Mo (thickness: 50 nm)/Al (thickness: 150 nm) in the same manner as Example 2, as a second circuit member. Pre-connection and main connection of the circuit connection material H were carried out in the same manner as the connection in Comparative Example 10, to obtain a connection structure for a circuit member for Comparative Example 11.

### (Comparative Example 12)

An IC was prepared in the same manner as Example 1 as the first circuit member. Next, a glass panel (thickness: 0.5 mm) was prepared comprising a circuit electrode (surface resistance: <40 Ω) with a 3-layer construction of IZO (outermost layer, thickness: 100 nm)/Mo (thickness: 50 nm)/Al (thickness: 150 nm) in the same manner as Example 3, as a second circuit member. Pre-connection of the circuit connection material H and the main connection were carried out in the same manner as the connection in Comparative Example 10, to obtain a connection structure for a circuit member for Comparative Example 12.

### [Evaluation of connection resistance]

Each connection structure for a circuit member obtained in the manner described above was used to measure the connection resistance between an IC gold bump electrode and a second circuit member electrode, with a multimeter (trade name: "Digital Multimeter" by Advantest Corp.), using a 4-point measurement method, whereby the difference in potential between the electrodes is extracted when a 1 mA constant current is introduced into the circuit. The connection resistance values were measured initially (immediately after connection), and after being held for 500 hours in a thermo-hygrostat at 85°C, 85% RH (high-temperature, high-humidity treatment) and standing for 30 minutes at room temperature (23°C).

Table 1 shows the measurement results for the connection resistance values for the connection structures of Examples 1-12 and Comparative Examples 1-12.

**[Table 1]**

| Example or Comparative Example | Circuit connection material | Electrode structure of 2nd connection member (glass panel) | Connection resistance value (Ω) | |
|---|---|---|---|---|
| | | | Initial | Post-treatment |
| Example 1 | A (Particles No.1) | ITO circuit | <1 | <5 |
| Example 2 | | ITO/Mo/Al circuit | <1 | <5 |
| Example 3 | | IZO/Mo/Al circuit | <1 | 5-10 |
| Example 4 | B (Particles No.1) | ITO circuit | <1 | <5 |
| Example 5 | | ITO/Mo/Al circuit | <1 | <5 |
| Example 6 | | IZO/Mo/Al circuit | <1 | <5 |
| Example 7 | E (Particles No.3) | ITO circuit | <1 | <5 |
| Example 8 | | ITO/Mo/Al circuit | <1 | <5 |
| Example 9 | | IZO/Mo/Al circuit | <1 | 5-10 |
| Example 10 | F (Particles No.3) | ITO circuit | <1 | <5 |
| Example 11 | | ITO/Mo/Al circuit | <1 | <5 |
| Example 12 | | IZO/Mo/Al circuit | <1 | <5 |
| Comp. Ex. 1 | C (Particles No.2) | ITO circuit | <1 | 5-10 |
| Comp. Ex. 2 | | ITO/Mo/Al circuit | <1 | <5 |
| Comp. Ex. 3 | | IZO/Mo/Al circuit | 1-5 | >20 |
| Comp. Ex. 4 | D (Particles No.2) | ITO circuit | <1 | <5 |
| Comp. Ex. 5 | | ITO/Mo/Al circuit | <1 | <5 |
| Comp. Ex. 6 | | IZO/Mo/Al circuit | 1-5 | >20 |
| Comp. Ex. 7 | G (Particles No.4) | ITO circuit | <1 | 10-20 |
| Comp. Ex. 8 | | ITO/Mo/Al circuit | 1-5 | 10-20 |
| Comp. Ex. 9 | | IZO/Mo/Al circuit | 1-5 | >20 |
| Comp. Ex. 10 | H (Particles No.4) | ITO circuit | <1 | 5-10 |
| Comp. Ex. 11 | | ITO/Mo/Al circuit | <1 | 5-10 |
| Comp. Ex. 12 | | IZO/Mo/Al circuit | 1-5 | >20 |

| | | | | |
|---|---|---|---|---|
| *Conductive particles No.1: Ni-plated particles (with protrusions)/compression modulus: 650 kgf/mm² No.2: Au/Ni-plated particles (with protrusions)/compression modulus: 650 kgf/mm² No.3: Ni-plated particles (with protrusions)/compression modulus: 400 kgf/mm² No.4: Ni-plated particles (with protrusions)/compression modulus: 90 kgf/mm² *Circuit connection material A, C, E, G: Main connecting conditions; 200°C, 100MPa, 10 sec B, D, F, H: Main connecting conditions; 160°C, 100MPa, 10 sec | | | | |

As shown in Table 1, upon comparing the connection resistance values initially and after high-temperature, high-humidity treatment, for the connection structures of Examples 1-12 that had circuit members with the entire circuit electrodes or the outermost layer sections thereof composed of ITO or IZO connected using circuit connection materials A, B, E and F, and the connection structures of Comparative Examples 1-12 that had the same circuit members connected using circuit connection materials C, D, G and H, the connection resistance values were improved either initially or after high-temperature, high-humidity treatment, as seen by comparison of Comparative Examples 1, 7 and Examples 1, 7, Comparative Examples 3, 9 and Examples 3, 9 and Comparative Examples 6, 12 and Examples 6, 12.

This demonstrated that, in a circuit electrode wherein the entire circuit electrode or the outermost layer is composed of ITO or IZO, enhanced electrical connection properties and improved connection reliability are obtained when connection is established using a circuit connection material comprising conductive particles having protrusions on the surfaces and an outermost layer of Ni, with a compression modulus of 100-800 kgf/mm² at 20% compression. In addition, the improved connection resistance is especially notable for a circuit electrode wherein the surface is composed of IZO which is smoother than ITO, suggesting that enhanced electrical connection properties can be achieved for flat circuit electrodes.

According to the connection structure of the invention it is possible to obtain stable connection reliability even in high-temperature, high-humidity environments and in thermal shock tests.

## Claims

1. A circuit connection material comprising an adhesive composition and conductive particles,
wherein the conductive particles are conductive particles with protrusions comprising one or more metal layers on a core,
the metal layer is formed on at least surfaces of the protrusions, the metal layer being composed of nickel or a nickel alloy, and
compression modulus of the conductive particles under 20% compression is 100-800 kgf/mm².

2. The circuit connection material according to claim 1, wherein heights of the protrusions are 65-500 nm.

3. The circuit connection material according to claim 1 or 2, wherein a distance between adjacent protrusions is not greater than 1000 nm.

4. The circuit connection material according to any one of claims 1 to 3,
wherein the adhesive composition comprises a film-forming material, an epoxy resin and a latent curing agent.

5. A connection structure for a circuit member, comprising
two circuit members having circuit electrodes formed thereon and situated with their circuit electrodes facing each other, and
a circuit-connecting member lying between the circuit members, which is heat-pressed to electrically connect the circuit electrodes,
wherein the circuit-connecting member is the circuit connection material according to any one of claims 1 to 4.

6. The connection structure for the circuit member according to claim 5,
wherein at least one of the two circuit members is an IC chip.

7. The connection structure for the circuit member according to claim 5 or 6, wherein a surface of at least one of the circuit electrodes of the two circuit members is composed of at least one material selected from the group consisting of gold, silver, tin, platinum-group metals, aluminum, titanium, molybdenum, chromium, indium-tin oxide and indium-zinc oxide.

8. The connection structure for the circuit member according to any one of claims 5 to 7, wherein a surface of at least one of the two circuit members is subjected to coating or adhesion treatment with at least one material selected from the group consisting of silicon nitride, silicone compounds and polyimide resins.

9. A connection method for a circuit member comprising a step of situating the circuit connection material according to any one of claims 1 to 4 between two circuit members having circuit electrodes formed thereon and situated with their circuit electrodes facing each other, and carrying out heat-pressing for electrical connection between the circuit electrodes.
